# EUROPEAN PATENT APPLICATION

(11) **EP 4 694 662 A1**
(43) Date of publication of application: **11.02.2026**
(21) Application number: 25791526.4
(22) Date of filing: 20.03.2025
(51) Int. Cl.: H10N 97/00

(54) **CAPACITOR DIELECTRIC LAYER, MANUFACTURING METHOD THEREFOR AND CAPACITOR STRUCTURE**

(30) Priority: 29.04.2024 CN 202410534542
(71) Applicant: CXMT Corporation, Hefei, Anhui 230601 (CN)
(72) Inventor: LI, Tao, Hefei, Anhui 230601 (CN); LI, Hui, Hefei, Anhui 230601 (CN); CHANG, Min-hui, Hefei, Anhui 230601 (CN); LI, Yongxiang, Hefei, Anhui 230601 (CN); ZHANG, Congcong, Hefei, Anhui 230601 (CN)
(74) Representative: Gulde & Partner
(86) International application number: PCT/CN2025/083698
(87) International publication number: WO 2025/227989

(57) **Abstract**

Disclosed are a capacitor dielectric layer, a manufacturing method therefor, and a capacitor structure. The capacitor dielectric layer includes any at least two stacked layers among a first stacked layer, a second stacked layer, and a third stacked layer, which are stacked along a first direction. Each stacked layer includes a first dielectric layer and a second dielectric layer. A main crystalline phase of the first dielectric layer is at least one of a tetragonal structure phase and an orthorhombic structure phase, and a main crystalline phase of the second dielectric layer is at least one of the tetragonal structure phase and the orthorhombic structure phase. The capacitor dielectric layer has a high dielectric constant and low leakage current.

## Description

The present disclosure claims priority to Chinese Patent Application No. 202410534542.0, filed with China National Intellectual Property Administration on April 29, 2024, and entitled "CAPACITOR DIELECTRIC LAYER, MANUFACTURING METHOD THEREFOR, AND CAPACITOR STRUCTURE", the content of which is incorporated herein by reference in its entirety.

### TECHNICAL FIELD

The embodiments of the present disclosure relate to the technical field of semiconductors, and specifically to a capacitor dielectric layer, a manufacturing method therefor, and a capacitor structure.

### BACKGROUND

With the continuous development of semiconductor chips, the critical dimensions thereof are constantly decreasing. Semiconductor chips, such as dynamic random access memory (DRAM, Dynamic Random Access Memory), include memory cells arranged in an array, and each memory cell includes a transistor and a capacitor. How to achieve a higher dielectric constant and lower leakage current in DRAM capacitors has become a critical focus in DRAM chip development.

### SUMMARY

According to a first aspect of the embodiments of the present disclosure, a capacitor dielectric layer is provided. The capacitor dielectric layer includes any at least two stacked layers among a first stacked layer, a second stacked layer, and a third stacked layer, which are stacked along a first direction, where the first stacked layer includes at least one first unit stacked along the first direction, the second stacked layer includes at least one second unit stacked along the first direction, and the third stacked layer includes at least one third unit stacked along the first direction; the first unit includes a first dielectric layer, a second dielectric layer, and a first dielectric layer, which are stacked along the first direction; the second unit includes the second dielectric layer and the first dielectric layer, which are stacked along the first direction; the third unit includes the first dielectric layer and the second dielectric layer, which are stacked along the first direction; a main crystalline phase of the first dielectric layer is at least one of a tetragonal structure phase and an orthorhombic structure phase, and a main crystalline phase of the second dielectric layer is at least one of the tetragonal structure phase and the orthorhombic structure phase.

In some embodiments, the capacitor dielectric layer further includes a barrier layer, where the barrier layer is disposed on each of the first stacked layer, the second stacked layer, and the third stacked layer.

In some embodiments, the capacitor dielectric layer includes the third stacked layer, the barrier layer, the first stacked layer, and the barrier layer, which are stacked along the first direction.

In some embodiments, the capacitor dielectric layer includes the third stacked layer, the barrier layer, the second stacked layer, and the barrier layer stacked along the first direction.

In some embodiments, the capacitor dielectric layer includes the first stacked layer, the barrier layer, the first stacked layer, and the barrier layer stacked along the first direction.

In some embodiments, the capacitor dielectric layer includes any two stacked layers among the first stacked layer, the second stacked layer, and the third stacked layer, which are stacked along the first direction, where a thickness ratio range of the two stacked layers is (0.4-2.5):1.

In some embodiments, Zₐ represents a first dielectric layer with a first thickness a, Z₂ₐ represents a first dielectric layer with a second thickness 2a, and the Z₂ₐ represents two of the Zₐ stacked along the first direction; H_{b} represents a second dielectric layer with a third thickness b, where
the first stacked layer is represented as ZₐH_{b}(Z₂ₐH_{b})_{c1-1}Zₐ; in the first stacked layer, the Zₐ, the H_{b}, (c1-1) sub-stacked structures composed of the Z₂ₐ and the H_{b}, and the Zₐ are stacked along the first direction; in each of the (c1-1) sub-stacked structures, the Z₂ₐ and the H_{b} are stacked along the first direction; a total thickness of the first stacked layer is 2.4 nm to 6 nm, and 1 ≤ a/b ≤ 20; the c1 represents the number of the first unit in the first stacked layer; the first unit is represented by a first stacked structure composed of Zₐ, H_{b}, and Zₐ stacked along the first direction; the c1 is a positive integer and satisfies 1 ≤ c1 ≤ 30; and/or,
the second stacked layer is represented as (H_{b}Zₐ)_{c2}; in the second stacked layer, c2 second units are stacked along the first direction; the second unit is represented by a second stacked structure composed of H_{b} and Zₐ stacked along the first direction; a total thickness of the second stacked layer is 2.4 nm to 6 nm, and 1 ≤ a/b ≤ 20; the c2 is a positive integer and satisfies 1 ≤ c2 ≤ 50; and/or,
the third stacked layer is represented as (ZₐH_{b})_{c3}; in the third stacked layer, c3 third units are stacked along the first direction; the third unit is represented by a third stacked structure composed of Zₐ and H_{b} stacked along the first direction; a total thickness of the third stacked layer is 2.4 nm to 6 nm, and 1 ≤ a/b ≤ 20; the c3 is a positive integer and satisfies 1 ≤ c3 ≤ 50.

In some embodiments, the barrier layer has a thickness of 0.07 nm to 0.4 nm.

In some embodiments, a total thickness of the capacitor dielectric layer is 5 nm to 9 nm.

In some embodiments, a material of the first dielectric layer includes zirconium oxide.

In some embodiments, a material of the second dielectric layer includes at least one of hafnium oxide, titanium oxide, niobium oxide, yttrium oxide, lanthanum oxide, and tantalum oxide.

In some embodiments, a material of the barrier layer includes at least one of aluminum oxide, silicon oxide, niobium oxide, silicon-doped niobium oxide, silicon-doped hafnium oxide, and lanthanum oxide; a bandgap of the barrier layer is greater than a bandgap of the first dielectric layer, and the bandgap of the barrier layer is greater than a bandgap of the second dielectric layer.

According to a second aspect of the embodiments of the present disclosure, a capacitor structure is provided. The capacitor structure includes a first electrode layer, a second electrode layer, and the capacitor dielectric layer as described in any of the first aspect. Moreover, the capacitor dielectric layer is disposed between the first electrode layer and the second electrode layer.

According to a third aspect of the embodiments of the present disclosure, a method for manufacturing a capacitor dielectric layer is provided. The manufacturing method includes: forming any at least two stacked layers among a first stacked layer, a second stacked layer, and a third stacked layer, which are stacked along a first direction, where
the first stacked layer includes at least one first unit stacked along the first direction, the second stacked layer includes at least one second unit stacked along the first direction, and the third stacked layer includes at least one third unit stacked along the first direction; the first unit includes a first dielectric layer, a second dielectric layer, and a first dielectric layer, which are stacked along the first direction; the second unit includes the second dielectric layer and the first dielectric layer, which are stacked along the first direction; the third unit includes the first dielectric layer and the second dielectric layer, which are stacked along the first direction; a main crystalline phase of the first dielectric layer is at least one of a tetragonal structure phase and an orthorhombic structure phase, and a main crystalline phase of the second dielectric layer is at least one of the tetragonal structure phase and the orthorhombic structure phase.

In some embodiments, the manufacturing method further includes: forming a barrier layer, where the barrier layer is formed on each of the first stacked layer, the second stacked layer, and the third stacked layer.

In some embodiments, the manufacturing method includes: forming the third stacked layer, the barrier layer, the first stacked layer, and the barrier layer stacked along the first direction.

In some embodiments, the manufacturing method includes: forming the third stacked layer, the barrier layer, the second stacked layer, and the barrier layer stacked along the first direction.

In some embodiments, the manufacturing method includes: forming the first stacked layer, the barrier layer, the first stacked layer, and the barrier layer stacked along the first direction.

In some embodiments, forming the any at least two stacked layers among the first stacked layer, the second stacked layer, and the third stacked layer, which are stacked along the first direction includes: forming any two stacked layers among the first stacked layer, the second stacked layer, and the third stacked layer, which are stacked along the first direction, a thickness ratio range of the two stacked layers being (0.4-2.5): 1.

In some embodiments, Zₐ represents a first dielectric layer with a first thickness a, Z₂ₐ represents a first dielectric layer with a second thickness 2a, and the Z₂ₐ represents two of the Zₐ stacked along the first direction; H_{b} represents a second dielectric layer with a third thickness b, where
forming the first stacked layer includes:
   (11) forming the Zₐ by using a first atomic layer deposition process, where a process of forming the Zₐ by using the first atomic layer deposition process includes a1 first sub-dielectric layer growth cycles which are cyclically performed; after completing each of the a1 first sub-dielectric layer growth cycles, a first sub-dielectric layer is formed, and a1 first sub-dielectric layers constitute the Zₐ;
   (12) forming the H_{b} along the first direction on the Zₐ formed in step (11) by using a second atomic layer deposition process, where a process of forming the H_{b} by using the second atomic layer deposition process includes b1 second sub-dielectric layer growth cycles which are cyclically performed; after completing each of the b1 second sub-dielectric layer growth cycles, a second sub-dielectric layer is formed, and b1 second sub-dielectric layers constitute the H_{b};
   (13) forming the Zₐ once again along the first direction on the H_{b} formed in step (12) by using a third atomic layer deposition process, where a process of forming the Zₐ by using the third atomic layer deposition process includes a1 first sub-dielectric layer growth cycles which are cyclically performed; after completing each of the a1 first sub-dielectric layer growth cycles, the first sub-dielectric layer is formed, and a1 first sub-dielectric layers constitute the Zₐ; the Zₐ, the H_{b}, and the Zₐ, which are formed along the first direction and arranged in a stacked manner, constitute one first unit; and
   (14) repeating steps (11) to (13) c1 times to obtain the first stacked layer, where a1, b1, and c1 satisfy: 1 ≤ a1/b1 ≤ 20, the c1 represents the number of the first unit in the first stacked layer, the c1 is a positive integer and satisfies 1 ≤ c1 ≤ 30, and 30 ≤ (2a1 + b1) * c1 ≤ 60; as well as satisfy: the first stacked layer is represented as ZₐH_{b}(Z₂ₐH_{b})_{c1-1}Zₐ; in the first stacked layer, the Zₐ, the H_{b}, (c1-1) sub-stacked structures composed of the Z₂ₐ and the H_{b}, and the Zₐ are stacked along the first direction; in each of the (c1-1) sub-stacked structures, the Z₂ₐ and the H_{b} are stacked along the first direction; a total thickness of the first stacked layer is 2.4 nm to 6 nm, and 1 ≤ a/b ≤ 20; and/or,
forming the second stacked layer includes:
   (21) forming the H_{b} by using a fourth atomic layer deposition process, where a process of forming the H_{b} by using the fourth atomic layer deposition process includes b2 second sub-dielectric layer growth cycles which are cyclically performed; after completing each of the b2 second sub-dielectric layer growth cycles, a second sub-dielectric layer is formed, and b2 second sub-dielectric layers constitute the H_{b};
   (22) forming the Zₐ along the first direction on the H_{b} formed in step (21) by using a fifth atomic layer deposition process, where a process of forming the Zₐ by using the fifth atomic layer deposition process includes a2 first sub-dielectric layer growth cycles which are cyclically performed; after completing each of the a2 first sub-dielectric layer growth cycles, a first sub-dielectric layer is formed, and a2 first sub-dielectric layers constitute the Zₐ; the H_{b} and the Zₐ, which are formed along the first direction and arranged in a stacked manner, constitute one second unit; and
   (23) repeating steps (21) to (22) c2 times to obtain the second stacked layer, where a2, b2, and c2 satisfy: 1 ≤ a2/b2 ≤ 20, the c2 represents the number of the second unit in the second stacked layer, the c2 is a positive integer and satisfies 1 ≤ c2 ≤ 50, and 30 ≤ (a2 + b2) * c2 ≤ 60; as well as satisfy: the second stacked layer is represented as (H_{b}Zₐ)_{c2}; in the second stacked layer, c2 second units are stacked along the first direction, a total thickness of the second stacked layer is 2.4 nm to 6 nm, and 1 ≤ a/b ≤ 20; and/or,
forming the third stacked layer includes:
   (31) forming the Zₐ by using a sixth atomic layer deposition process, where a process of forming the Zₐ by using the sixth atomic layer deposition process includes a3 first sub-dielectric layer growth cycles which are cyclically performed; after completing each of the a3 first sub-dielectric layer growth cycles, a first sub-dielectric layer is formed, and a3 first sub-dielectric layers constitute the Zₐ;
   (32) forming the H_{b} along the first direction on the Zₐ formed in step (31) by using a seventh atomic layer deposition process, where a process of forming the H_{b} by using the seventh atomic layer deposition process includes b3 second sub-dielectric layer growth cycles which are cyclically performed; after completing each of the b3 second sub-dielectric layer growth cycles, a second sub-dielectric layer is formed, and b3 second sub-dielectric layers constitute the H_{b}; the Zₐ and the H_{b}, which are formed along the first direction and arranged in a stacked manner, constitute one third unit; and
   (33) repeating steps (31) to (32) c3 times to obtain the third stacked layer, where a3, b3, and c3 satisfy: 1 ≤ a3/b3 ≤ 20, the c3 represents the number of the third unit in the third stacked layer, the c3 is a positive integer and satisfies 1 ≤ c3 ≤ 50, and 30 ≤ (a3 + b3) * c3 ≤ 60; as well as satisfy: the third stacked layer is represented as (ZₐH_{b})_{c3}; in the third stacked layer, c3 third units are stacked along the first direction, a total thickness of the third stacked layer is 2.4 nm to 6 nm, and 1 ≤ a/b ≤ 20.

In some embodiments, forming the barrier layer includes: forming the barrier layer by using an eighth atomic layer deposition process, where a process of forming the barrier layer by using the eighth atomic layer deposition process includes d1 sub-barrier layer growth cycles which are cyclically performed; after completing each of the d1 sub-barrier layer growth cycles, a sub-barrier layer is formed, and d1 sub-barrier layers constitute the barrier layer; d1 ranges from 1 to 4, and a thickness satisfying the barrier layer ranges from 0.07 nm to 0.4 nm.

In the embodiments of the present disclosure, the capacitor dielectric layer is a stacked structure arranged in a stacked manner. The capacitor dielectric layer includes any at least two stacked layers among a first stacked layer, a second stacked layer, and a third stacked layer, which are stacked along a first direction, where the first stacked layer includes at least one first unit stacked along the first direction, the second stacked layer includes at least one second unit stacked along the first direction, and the third stacked layer includes at least one third unit stacked along the first direction; the first unit includes a first dielectric layer, a second dielectric layer, and a first dielectric layer, which are stacked along the first direction; the second unit includes the second dielectric layer and the first dielectric layer, which are stacked along the first direction; the third unit includes the first dielectric layer and the second dielectric layer, which are stacked along the first direction; a main crystalline phase of the first dielectric layer is at least one of a tetragonal structure phase and an orthorhombic structure phase (primarily the tetragonal structure phase), and a main crystalline phase of the second dielectric layer is at least one of the tetragonal structure phase and the orthorhombic structure phase (primarily the tetragonal structure phase). In the stacked structure including at least two stacked layers, the second dielectric layer (e.g., hafnium oxide layer), which has a main crystalline phase of at least one of the tetragonal structure phase and the orthorhombic structure phase, may be made of a ferroelectric material that exhibits ferroelectric properties or antiferroelectric properties depending on the electric field. By using the second dielectric layer (e.g., the hafnium oxide layer) with ferroelectric properties or antiferroelectric properties, the dielectric constant value of the stacked structure is increased. Such a stacked structure can satisfy the requirement for a higher dielectric constant and lower leakage current, for example, satisfying the requirement of the capacitor for a high capacitance value and low leakage current.

### BRIEF DESCRIPTION OF DRAWINGS

FIG. 1 is a schematic cross-sectional diagram of a capacitor dielectric layer according to an exemplary embodiment of the present disclosure;
FIG. 2 is a schematic cross-sectional diagram of a capacitor dielectric layer according to another exemplary embodiment of the present disclosure;
FIG. 3 is a schematic cross-sectional diagram of a capacitor dielectric layer according to another exemplary embodiment of the present disclosure;
FIG. 4 is a schematic cross-sectional diagram of a capacitor dielectric layer according to another exemplary embodiment of the present disclosure;
FIG. 5 is a schematic cross-sectional diagram of a capacitor dielectric layer according to another exemplary embodiment of the present disclosure;
FIG. 6 is a schematic cross-sectional diagram of a first stacked layer according to an exemplary embodiment of the present disclosure;
FIG. 7 is a schematic cross-sectional diagram of a second stacked layer according to an exemplary embodiment of the present disclosure;
FIG. 8 is a schematic cross-sectional diagram of a third stacked layer according to an exemplary embodiment of the present disclosure;
FIG. 9 is a schematic diagram of a process for manufacturing the capacitor dielectric layer shown in FIG. 3 according to the present disclosure;
FIG. 10 is a schematic diagram of a process for manufacturing the capacitor dielectric layer shown in FIG. 4 according to the present disclosure;
FIG. 11 is a schematic diagram of a process for manufacturing the capacitor dielectric layer shown in FIG. 5 according to the present disclosure;
FIG. 12 is a schematic diagram of a process for manufacturing the first stacked layer shown in FIG. 6 according to the present disclosure;
FIG. 13 is a schematic diagram of a process for manufacturing the second stacked layer shown in FIG. 7 according to the present disclosure; and
FIG. 14 is a schematic diagram of a process for manufacturing the third stacked layer shown in FIG. 8 according to the present disclosure.

### DESCRIPTION OF EMBODIMENTS

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. The advantages and features of the present disclosure will become apparent from the following description and claims. It should be noted that the drawings are all in a very simplified form and not to a precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between the top surface and the bottom surface of a continuous structure, or a layer may be located between any pair of horizontal planes at the top surface and the bottom surface of the continuous structure. A layer may extend horizontally, perpendicularly, and/or along inclined surfaces. A layer may include a plurality of sub-layers.

It should be noted that unless conflicting, the technical solutions described in the embodiments of the present disclosure may be arbitrarily combined.

The term "high dielectric constant" refers to a dielectric constant value greater than 3.9, and "high dielectric constant material" refers to materials with a dielectric constant greater than 3.9.

To have a more detailed understanding of the characteristics and technical content of the embodiments of the present disclosure, the implementation of the embodiments of the present disclosure is described in detail in combination with the drawings. The attached drawings are for the purposes of reference and explanation only and are not used to limit the embodiments of the present disclosure.

With the development of dynamic random access memory technology, the dimensions of memory cells have become increasingly smaller, and the array architecture has evolved from 8F² to 6F² and then to 4F². The memory architecture has transitioned from planar array transistors (Planar Array Transistor) to recess gate array transistors (Recess Gate Array Transistor), then from recess gate array transistors to buried channel array transistors (Buried Channel Array Transistor), and further from buried channel array transistors to vertical channel array transistors (Vertical Channel Array Transistor).

In some embodiments of the present disclosure, whether for planar transistors or buried transistors, dynamic random access memory includes a plurality of memory cells. Each memory cell is primarily composed of one transistor and one storage structure (storage capacitor) controlled by the transistor; that is, dynamic random access memory includes a one-transistor (T, Transistor)- and-one-capacitor (C, Capacitor) (1T1C) architecture. The primary operating principle is to represent a binary bit as either 1 or 0 based on the amount of electric charge stored in the capacitor.

The capacitor dielectric layer involved in the embodiments of the present disclosure is to be used in subsequent processes to form at least a portion of the final device structure.

Here, the final device may include capacitors, memory, and others. The memory includes, but is not limited to, DRAM. The following explanation will take DRAM as an example.

However, it should be noted that the following descriptions regarding DRAM in the embodiments are only intended to illustrate the present disclosure and are not intended to limit the scope of the present disclosure.

With the development of DRAM technology, the dimensions of memory cells have become increasingly smaller. Achieving a higher dielectric constant and lower leakage current in DRAM capacitors has become a critical factor determining the success or failure of DRAM chip development. Developing a capacitor dielectric layer with a higher dielectric constant and lower leakage current has become an urgent issue to address.

The dielectric constant K value of silicon is approximately 11.5. Currently, the capacitor dielectric layer primarily relies on crystallizing zirconium oxide (ZrO) into a tetragonal structure phase to achieve a high dielectric constant (approximately 47). As a result, zirconium oxide is widely used in DRAM capacitors. Zirconium oxide can crystallize at a certain thickness within the temperature range of 260 °C to 350 °C to form a monoclinic phase, cubic structure phase, or tetragonal structure phase. In contrast, hafnium oxide (HfO) typically remains amorphous or forms a monoclinic phase when deposited as a thin film at 300 °C. Pure hafnium oxide, when applied in High-K thin films, cannot achieve a high dielectric constant (the dielectric constant K value is relatively low, generally around 25) and may even result in thin-film materials with high leakage currents. However, hafnium oxide with a tetragonal structure phase can have a dielectric constant K value of up to 70. The key lies in forming a hafnium oxide layer with a tetragonal structure phase or even an orthorhombic structure phase. Therefore, forming a capacitor dielectric layer with a stacked structure including a first dielectric layer (e.g., zirconium oxide) and a second dielectric layer (e.g., hafnium oxide) becomes critically important. Such a capacitor dielectric layer allows both the first dielectric layer (e.g., zirconium oxide) and the second dielectric layer (e.g., hafnium oxide) to crystallize simultaneously, with the main crystalline phases of the first dielectric layer (e.g., zirconium oxide) and the second dielectric layer (e.g., hafnium oxide) being the tetragonal structure phase or even the orthorhombic structure phase. As a result, a high-K material with a high dielectric constant and low leakage current can be achieved.

The embodiments of the present disclosure provide a capacitor dielectric layer, a manufacturing method therefor, and a capacitor structure.

Here and hereinafter, the first direction refers to the direction parallel to the thickness of each process layer, which may also be understood as the stacking direction of the formed process layers. Specifically, the first direction may refer to the direction parallel to the thickness of each process layer from the second electrode layer (e.g., the lower electrode layer) to the first electrode layer (e.g., the upper electrode layer) in the capacitor structure. The second direction and the third direction are defined as two orthogonal directions that are perpendicular to the thickness direction of the process layers. Exemplarily, the first direction is denoted as the Z direction in the figures; the second direction is denoted as the X direction in the figures; and the third direction is denoted as the Y direction in the figures.

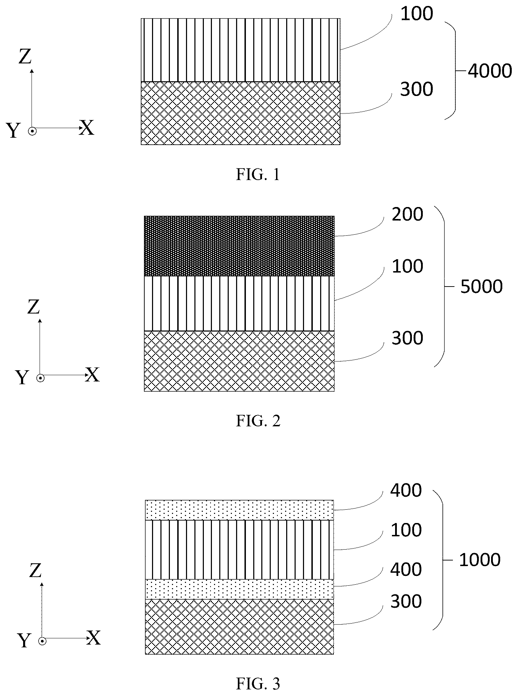

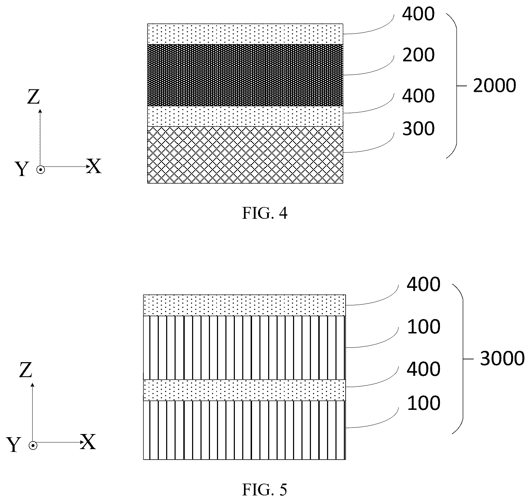

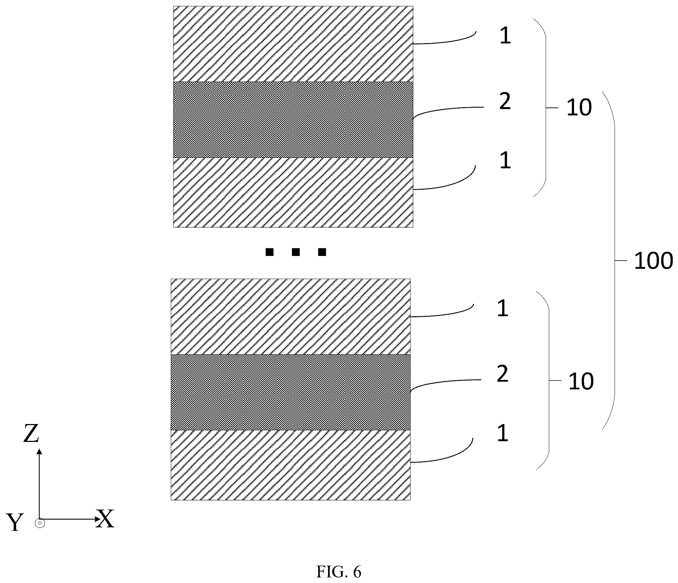

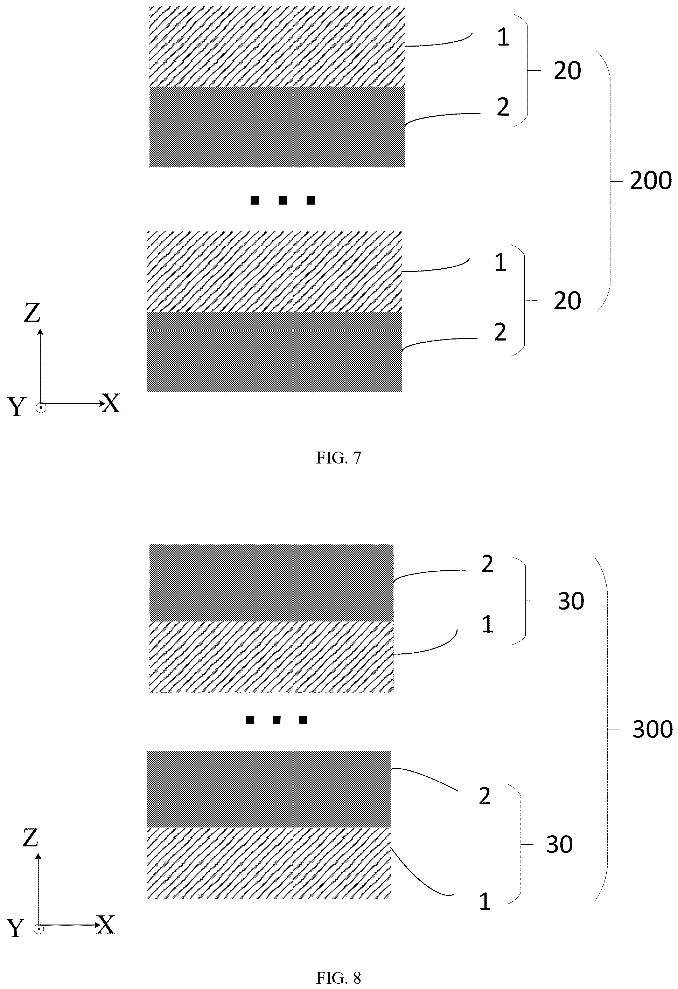

FIG. 1 is a schematic cross-sectional diagram of a capacitor dielectric layer according to an exemplary embodiment of the present disclosure; FIG. 2 is a schematic cross-sectional diagram of a capacitor dielectric layer according to another exemplary embodiment of the present disclosure; FIG. 3 is a schematic cross-sectional diagram of a capacitor dielectric layer according to another exemplary embodiment of the present disclosure; FIG. 4 is a schematic cross-sectional diagram of a capacitor dielectric layer according to another exemplary embodiment of the present disclosure; FIG. 5 is a schematic cross-sectional diagram of a capacitor dielectric layer according to another exemplary embodiment of the present disclosure; FIG. 6 is a schematic cross-sectional diagram of a first stacked layer according to an exemplary embodiment of the present disclosure; FIG. 7 is a schematic cross-sectional diagram of a second stacked layer according to an exemplary embodiment of the present disclosure; and FIG. 8 is a schematic cross-sectional diagram of a third stacked layer according to an exemplary embodiment of the present disclosure. The structure of the capacitor dielectric layer will be described in conjunction with FIGS. 1 to 8.

According to a first aspect of the embodiments of the present disclosure, as shown in FIGS. 1 to 8, a capacitor dielectric layer is provided. The capacitor dielectric layer includes any at least two stacked layers among a first stacked layer, a second stacked layer, and a third stacked layer, which are stacked along the first direction. The first stacked layer includes at least one first unit stacked along the first direction, the second stacked layer includes at least one second unit stacked along the first direction, and the third stacked layer includes at least one third unit stacked along the first direction. The first unit includes a first dielectric layer, a second dielectric layer, and a first dielectric layer, which are stacked along the first direction. The second unit includes the second dielectric layer and the first dielectric layer, which are stacked along the first direction. The third unit includes the first dielectric layer and the second dielectric layer, which are stacked along the first direction. The main crystalline phase of the first dielectric layer is at least one of a tetragonal structure phase and an orthorhombic structure phase. The main crystalline phase of the second dielectric layer is at least one of a tetragonal structure phase and an orthorhombic structure phase.

Here and in the following embodiments, for ease of description, the capacitor dielectric layer is of a stacked structure. The term "stacked structure" requires adaptive interpretation based on specific embodiments or application scenarios, and unless explicitly stated otherwise, it is not intended to limit the embodiments of the present disclosure. Exemplarily, in the embodiments of the present disclosure, the capacitor dielectric layer includes any at least two stacked layers among the first stacked layer, the second stacked layer, and the third stacked layer, which are stacked along the first direction (for example, as shown in FIG. 1, the capacitor dielectric layer 4000 includes the third stacked layer 300 and the first stacked layer 100 stacked along the first direction Z; as shown in FIG. 2, the capacitor dielectric layer 5000 includes the third stacked layer 300, the first stacked layer 100, and the second stacked layer 200 stacked along the first direction Z; at least two stacked layers can be arbitrarily selected from the first stacked layer, the second stacked layer, and the third stacked layer, and all combinations of stacked layers are not individually shown here). In some of the following embodiments, the capacitor dielectric layer includes any at least two stacked layers among the first stacked layer, the second stacked layer, and the third stacked layer, which are stacked along the first direction, as well as a barrier layer. The barrier layer is disposed on each of the first stacked layer, the second stacked layer, and the third stacked layer (for example, as shown in FIGS. 3 to 5, a barrier layer 400 is arranged on each stacked layer, and the at least two stacked layers can be arbitrarily selected from the first stacked layer, the second stacked layer, and the third stacked layer, and all combinations of stacked layers are not individually shown here).

In some embodiments, as shown in FIG. 6, the first stacked layer 100 includes at least one first unit 10 stacked along the first direction Z. The first unit 10 includes a first dielectric layer 1, a second dielectric layer 2, and a first dielectric layer 1, which are stacked along the first direction Z.

In some embodiments, as shown in FIG. 7, the second stacked layer 200 includes at least one second unit 20 stacked along the first direction Z. The second unit 20 includes the second dielectric layer 2 and the first dielectric layer 1, which are stacked along the first direction Z.

In some embodiments, as shown in FIG. 8, the third stacked layer 300 includes at least one third unit 30 stacked along the first direction Z. The third unit 30 includes the first dielectric layer 1 and the second dielectric layer 2, which are stacked along the first direction Z.

In the embodiments of the present disclosure, the main crystalline phase of the first dielectric layer is at least one of a tetragonal structure phase and an orthorhombic structure phase, and the main crystalline phase of the second dielectric layer is at least one of a tetragonal structure phase and an orthorhombic structure phase. This can be understood as follows: the main crystalline phases of the first dielectric layer and the second dielectric layer are independently one or both of the tetragonal structure phase and the orthorhombic structure phase. For example, in one specific embodiment, the main crystalline phase of the first dielectric layer is the tetragonal structure phase, and the main crystalline phase of the second dielectric layer is the tetragonal structure phase and/or the orthorhombic structure phase (when both the tetragonal structure phase and the orthorhombic structure phase are included, the crystalline phase is still predominantly made up of the tetragonal structure phase). When the main crystalline phase of the first dielectric layer is the tetragonal structure phase, it can be specifically understood as follows: With the cross-section of the capacitor dielectric layer as the reference, the crystalline phase of 80 area%, 85 area%, or more than 95 area% of the capacitor dielectric layer is the tetragonal structure phase. When the main crystalline phase of the second dielectric layer is the tetragonal structure phase and/or the orthorhombic structure phase, it can be specifically understood as follows: With the cross-section of the capacitor dielectric layer as the reference, the crystalline phase of 80 area%, 85 area%, or more than 95 area% of the capacitor dielectric layer is the tetragonal structure phase and/or the orthorhombic structure phase (when both the tetragonal structure phase and the orthorhombic structure phase are included, the crystalline phase is still predominantly made up of the tetragonal structure phase). Other types of main crystalline phases can be understood in the same manner, which will not be detailed here.

The capacitor dielectric layer with a stacked structure may be made of a ferroelectric material that exhibits ferroelectric properties or antiferroelectric properties depending on the electric field. The dielectric constant of the ferroelectric material can greatly increase within a switching voltage range. The switching voltage range refers to a voltage range in which a transition from ferroelectric properties to antiferroelectric properties or from antiferroelectric properties to ferroelectric properties may occur. Therefore, the capacitor can exhibit a high dielectric constant within the operating voltage range.

The second dielectric layer, whose main crystalline phase is at least one of a tetragonal structure phase and an orthorhombic structure phase (e.g., a hafnium oxide layer with a tetragonal structure phase as the main crystalline phase), may be made of a ferroelectric material that exhibits ferroelectric properties or antiferroelectric properties depending on the electric field. The dielectric constant value of the stacked structure can be increased by using a second dielectric layer exhibiting ferroelectric properties or antiferroelectric properties (for example, a hafnium oxide layer with a tetragonal structure phase as the main crystalline phase). The hafnium oxide layer with a tetragonal structure phase can have a dielectric constant value of 70 or higher, while a hafnium oxide layer with a monoclinic crystalline phase or an amorphous hafnium oxide layer will not exhibit ferroelectric properties. Its dielectric constant K value is relatively low, generally around 25, and the dielectric constant K value is not high. Such a stacked structure can meet the requirement for a high dielectric constant, for example, to satisfy the requirement of the capacitor for a high capacitance value.

Therefore, the dielectric constant of the capacitor dielectric layer in capacitors can be increased by a second dielectric layer exhibiting ferroelectric properties (e.g., a hafnium oxide layer with a tetragonal structure phase as the main crystalline phase).

In the embodiments of the present disclosure, the capacitor dielectric layer further includes a barrier layer, which is disposed on each of the first stacked layer, the second stacked layer, and the third stacked layer.

In the embodiments of the present disclosure, arranging a barrier layer on each of the first stacked layer, the second stacked layer, and the third stacked layer can further block the leakage paths of the capacitor dielectric layer, which is beneficial for improving the capacitance value of the capacitor dielectric layer and reducing the leakage current. Therefore, the capacitor dielectric layer including the barrier layer can meet the requirements of a high dielectric constant and low leakage current, for example, satisfying the requirement of the capacitor for a high capacitance value and low leakage current.

In the embodiments of the present disclosure, the thickness of the barrier layer is 0.07 nm to 0.4 nm. The blocking effect of the barrier layer on leakage current is not highly correlated with the thickness. To enable the control of the dielectric constant K value by the first dielectric layer and the second dielectric layer, and to avoid a significant impact on the dielectric constant K value caused by excessive thickness of the barrier layer, the thickness of the barrier layer needs to be controlled within the range of 0.07 nm to 0.4 nm.

In one embodiment of the present disclosure, Zₐ represents a first dielectric layer with a first thickness a, Z₂ₐ represents a first dielectric layer with a second thickness 2a, and the Z₂ₐ represents two Zₐ stacked along the first direction; H_{b} represents a second dielectric layer with a third thickness b.

The first stacked layer is represented as ZₐH_{b}(Z₂ₐH_{b})_{c1-1}Zₐ. In the first stacked layer, the Zₐ, the H_{b}, (c1-1) sub-stacked structures composed of the Z₂ₐ and the H_{b}, and the Zₐ are stacked along the first direction Z. In each sub-stacked structure, the Z₂ₐ and the H_{b} are stacked along the first direction Z. The total thickness of the first stacked layer is 2.4 nm to 6 nm, and 1 ≤ a/b ≤ 20; the c1 represents the number of the first unit in the first stacked layer. The first unit is represented by a first stacked structure composed of Zₐ, H_{b}, and Zₐ stacked along the first direction Z. The c1 is a positive integer and satisfies 1 ≤ c1 ≤ 30. In the first stacked layer, the bottom first dielectric layer (e.g., zirconium oxide layer) serves as the nucleation phase and crystallizes into a tetragonal structure phase. On the basis of nucleation from the bottom first dielectric layer, the second dielectric layer (e.g., hafnium oxide layer) continues to nucleate. After reaching a certain thickness, the second dielectric layer can crystallize. If the first dielectric layer is further deposited, the surface energy of the first dielectric layer and the second dielectric layer can be effectively reduced, thus reducing the formation of the monoclinic crystalline phase (M-phase) and increasing the probability of the second dielectric layer (e.g., hafnium oxide layer) forming a tetragonal structure phase.

The second stacked layer is represented as (H_{b}Zₐ)_{c2}. In the second stacked layer, c2 second units are stacked along the first direction Z. The second unit is represented by a second stacked structure composed of H_{b} and Zₐ stacked along the first direction Z. The total thickness of the second stacked layer is 2.4 nm to 6 nm, and 1 ≤ a/b ≤ 20; the c2 is a positive integer and satisfies 1 ≤ c2 ≤ 50. In the second stacked layer, the bottom second dielectric layer (e.g., hafnium oxide layer) serves as the substrate and does not crystallize. The first dielectric layer (e.g., zirconium oxide layer), when deposited to a certain thickness on the second dielectric layer (e.g., hafnium oxide layer), will spontaneously crystallize into a tetragonal structure phase, which induces the second dielectric layer (e.g., hafnium oxide layer) to nucleate and crystallize into a tetragonal structure phase. As a result, the second stacked layer also exhibits good crystallization consistency.

The third stacked layer is represented as (ZₐH_{b})_{c3}. In the third stacked layer, c3 third units are stacked along the first direction Z. The third unit is represented by a third stacked structure composed of Zₐ and H_{b} stacked along the first direction Z. The total thickness of the third stacked layer is 2.4 nm to 6 nm, and 1 ≤ a/b ≤ 20; the c3 is a positive integer and satisfies 1 ≤ c3 ≤ 50. In the third stacked layer, the bottom first dielectric layer (e.g., zirconium oxide layer) serves as the nucleation phase and crystallizes into a tetragonal structure phase. On the basis of nucleation from the bottom first dielectric layer (e.g., zirconium oxide layer), the second dielectric layer (e.g., hafnium oxide layer) continues to nucleate. After reaching a certain thickness, the second dielectric layer can crystallize into a tetragonal structure phase.

In the present disclosure, by controlling the specific combinations and proportions of the first dielectric layer (e.g., zirconium oxide layer) and the second dielectric layer (e.g., hafnium oxide layer), the first dielectric layer (e.g., zirconium oxide layer) and the second dielectric layer (e.g., hafnium oxide layer) exhibit nearly identical lattice parameters. By adjusting the thickness ratio of the first dielectric layer (e.g., zirconium oxide layer) in the stacked layer, the energy barrier required for the crystallization of the second dielectric layer (e.g., hafnium oxide layer) can be effectively reduced, thereby altering the crystallization state of the second dielectric layer (e.g., hafnium oxide layer). Moreover, by forming a barrier layer on the stacked layer, the leakage paths in the capacitor dielectric layer can also be effectively blocked.

The a/b ratio determines which structure phase is formed (e.g., monoclinic phase, cubic structure phase, tetragonal structure phase, or orthorhombic structure phase). The higher the a/b ratio, the higher the probability of forming a tetragonal structure phase, and the higher the dielectric constant of the resulting capacitor dielectric layer. However, the a/b ratio should not be overly large, as an overly large ratio can lead to an excessively large crystalline grain. When the a/b ratio decreases, the stress caused by certain lattice mismatches at the interface between the first dielectric layer (e.g., zirconium oxide layer) and the second dielectric layer (e.g., hafnium oxide layer) is relaxed. This makes it easier for the second dielectric layer (e.g., hafnium oxide layer) to transition from the tetragonal structure phase to the monoclinic crystalline phase, which is not beneficial for improving the dielectric constant K value of the stacked structure. Therefore, it is necessary to control the a/b ratio to control the degree of crystallization, ensuring that more tetragonal structure phases are formed while preventing the crystalline grains from growing excessively large. Therefore, based on the above considerations, 1 ≤ a/b ≤ 20, preferably 3 ≤ a/b ≤ 5.

The total thickness of the first stacked layer, second stacked layer, and third stacked layer is independently set to 2.4 nm to 6 nm. Maintaining the thickness of each stacked layer within this range is critical to achieving the crystallization of the second dielectric layer (e.g., hafnium oxide layer). Such thickness ensures that there exists stress caused by certain lattice mismatches at the interface between the first dielectric layer with a tetragonal structure phase and the second dielectric layer (e.g., hafnium oxide layer) with a tetragonal structure phase, and the stress can be prevented from being relaxed. This allows the second dielectric layer (e.g., hafnium oxide layer) to form a tetragonal structure phase under the influence of the stress while avoiding the formation of a monoclinic crystalline phase, which is beneficial for improving the dielectric constant K value of the stacked structure.

Therefore, by controlling the a/b ratio, the total thickness of the first stacked layer, second stacked layer, and third stacked layer, and the values of c1, c2, and c3, there exists the stress caused by certain lattice mismatches at the interface between the first dielectric layer with a tetragonal structure phase and the second dielectric layer (e.g., hafnium oxide layer) with a tetragonal structure phase. The existence of the stress allows the second dielectric layer (e.g., hafnium oxide layer) to deposit as a thin film with a tetragonal crystal phase within a specific thickness range, thereby minimizing the Gibbs free energy of the entire stacked structure system. The second dielectric layer with a tetragonal crystalline phase may be made of a ferroelectric material that exhibits ferroelectric properties or antiferroelectric properties depending on the electric field. The second dielectric layer with ferroelectric properties or antiferroelectric properties can be used to increase the dielectric constant value of the entire stacked structure, such that the dielectric constant K value of the entire stacked structure can be improved, thereby achieving maximization of the K value. The resulting capacitor dielectric layer can meet the requirements of a high dielectric constant and lower leakage current.

In one embodiment of the present disclosure, the total thickness of the capacitor dielectric layer may be 5 nm to 9 nm.

In one embodiment of the present disclosure, the material of the first dielectric layer includes zirconium oxide.

In one embodiment of the present disclosure, the material of the second dielectric layer includes at least one of hafnium oxide, titanium oxide, niobium oxide, yttrium oxide, lanthanum oxide, and tantalum oxide.

In one embodiment of the present disclosure, the material of the barrier layer includes at least one of aluminum oxide, silicon oxide, niobium oxide, silicon-doped niobium oxide, silicon-doped hafnium oxide, and lanthanum oxide. The bandgap of the barrier layer is greater than the bandgap of the first dielectric layer, and the bandgap of the barrier layer is greater than the bandgap of the second dielectric layer. In silicon-doped niobium oxide, the atomic ratio of silicon to niobium is 1:(1-20); in silicon-doped hafnium oxide, the atomic ratio of silicon to hafnium is 1:(1-20).

The total thickness of the first stacked layer, second stacked layer, and third stacked layer can help ensure a higher dielectric constant K value as the DRAM critical dimension continues to shrink. The total thickness of the first stacked layer, second stacked layer, and third stacked layer is greater than the thickness of the barrier layer, with the first stacked layer, second stacked layer, and third stacked layer primarily determining the capacitance value of the entire capacitor. In some specific embodiments, the total thickness of the first stacked layer, second stacked layer, and third stacked layer is 2.4 nm to 6 nm, using materials with a relatively high dielectric constant, such as at least one of the high-K dielectric materials including zirconium oxide, hafnium oxide, titanium oxide, niobium oxide, yttrium oxide, lanthanum oxide, and tantalum oxide. For example, the first stacked layer, second stacked layer, and third stacked layer include zirconium oxide layers and hafnium oxide layers stacked sequentially; the barrier layer includes an aluminum oxide layer. Compared to the barrier layer, the zirconium oxide layer and the hafnium oxide layer have a higher dielectric constant K value but also a higher leakage rate, whereas the aluminum oxide layer has a lower dielectric constant K value but also a lower leakage rate. Therefore, by adopting the capacitor dielectric layer with a stacked structure including the stacked layers and the barrier layer, both a high dielectric constant K value and reduced leakage rate can be achieved.

The inventors of the present disclosure have creatively discovered through research that, in the aforementioned capacitor dielectric layer, there exist various combinations of the first stacked layer, the second stacked layer, and the third stacked layer forming the capacitor dielectric layer. These combinations include, but are not limited to, a capacitor dielectric layer formed by two of the first stacked layer, the second stacked layer, and the third stacked layer arranged in different manners with a barrier layer, and a capacitor dielectric layer formed by all three of the first stacked layer, the second stacked layer, and the third stacked layer arranged in different manners with a barrier layer. Among the numerous combination methods, compared to other forms of capacitor dielectric layers (where the proportion of the tetragonal structure phase is at most 80%, the dielectric constant is at most 35, and under a voltage range of -0.6 V to 0.6 V, the leakage current ranges from -5e⁻⁵ pA to 5e⁻⁵ pA/cell), the capacitor dielectric layers formed by the following three arrangement methods exhibit significantly higher dielectric constants and notably lower leakage currents.

In one embodiment of the present disclosure, the capacitor dielectric layer includes any two stacked layers among the first stacked layer, the second stacked layer, and the third stacked layer, which are stacked along the first direction. The thickness ratio range of the two stacked layers is (0.4-2.5):1. Within this thickness ratio range, the capacitor dielectric layer can achieve a high dielectric constant K value.

In one embodiment of the present disclosure, as shown in FIG. 3, the capacitor dielectric layer 1000 includes a third stacked layer 300, a barrier layer 400, a first stacked layer 100, and a barrier layer 400, which are stacked along the first direction Z. As shown in FIG. 6, the first stacked layer 100 includes at least one first unit 10 stacked along the first direction Z. The first unit 10 includes a first dielectric layer 1, a second dielectric layer 2, and a first dielectric layer 1, which are stacked along the first direction Z. As shown in FIG. 8, the third stacked layer 300 includes at least one third unit 30 stacked along the first direction Z. The third unit 30 includes the first dielectric layer 1 and the second dielectric layer 2, which are stacked along the first direction Z. The thickness ratio of the third stacked layer 300 to the first stacked layer 100 is (0.4-2.5): 1. The thickness of each barrier layer is 0.07 nm to 0.4 nm, and the total thickness of the capacitor dielectric layer is 5 nm to 9 nm. The respective parameter ranges of the first stacked layer ZₐH_{b}(Z₂ₐH_{b})c₁₋₁Zₐ and the third stacked layer (ZₐH_{b})_{c3} are as previously described. The main crystalline phase of the first dielectric layer 1 is at least one of a tetragonal structure phase or an orthorhombic structure phase (specifically, a tetragonal structure phase), and the main crystalline phase of the second dielectric layer 2 is at least one of a tetragonal structure phase or an orthorhombic structure phase (specifically, a tetragonal structure phase).

In this embodiment, taking zirconium oxide as an example for the first dielectric layer 1 and hafnium oxide as an example for the second dielectric layer 2, the growth of zirconium oxide and hafnium oxide (ZrHf) is performed first. Hafnium oxide can undergo epitaxial growth based on the crystallization of zirconium oxide, thereby reducing the energy required for hafnium oxide crystallization and facilitating the formation of the tetragonal structure phase. A barrier layer (e.g., aluminum oxide), composed of elements with a high bandgap, is formed on the stacked layer. On the one hand, this can reduce leakage paths, and on the other hand, doping of the barrier layer (e.g., aluminum) can prevent the growth of ZrHf crystalline grains. After the growth of zirconium oxide-hafnium oxide-zirconium oxide (ZHZ), the incorporation of the first barrier layer (e.g., aluminum) inhibits ZrHf crystallization, promoting the growth of a small amount of metastable orthorhombic structure phase (O phase). At the grain boundaries between the orthorhombic structure phase (O phase) (5% to 10%) and the tetragonal structure phase (T phase) (80% to 90%), a morphotropic phase boundary (Morphotropic phase boundary, MPB) is formed. This phase boundary achieves a dielectric constant higher than that of the orthorhombic structure phase (O phase) and the tetragonal structure phase (T phase), specifically reaching a value of 39 to 41. Under a voltage range of -0.6 V to 0.6 V, the leakage current of the capacitor dielectric layer in this embodiment ranges from -2e⁻⁵ pA to 2e⁻⁵ pA/cell.

In one embodiment of the present disclosure, as shown in FIG. 4, the capacitor dielectric layer 2000 includes a third stacked layer 300, a barrier layer 400, a second stacked layer 200, and a barrier layer 400, which are stacked along the first direction Z. As shown in FIG. 7, the second stacked layer 200 includes at least one second unit 20 stacked along the first direction Z. The second unit 20 includes a second dielectric layer 2 and a first dielectric layer 1, which are stacked along the first direction Z. As shown in FIG. 8, the third stacked layer 300 includes at least one third unit 30 stacked along the first direction Z. The third unit 30 includes the first dielectric layer 1 and the second dielectric layer 2, which are stacked along the first direction Z. The thickness ratio of the third stacked layer 300 to the second stacked layer 200 is (0.4-2.5): 1. The thickness of each barrier layer is 0.07 nm to 0.4 nm, and the total thickness of the capacitor dielectric layer is 5 nm to 9 nm. The respective parameter ranges of the third stacked layer (ZₐH_{b})c₃ and the second stacked layer (H_{b}Zₐ)_{c2} are as previously described. The main crystalline phase of the first dielectric layer 1 is at least one of a tetragonal structure phase or an orthorhombic structure phase (specifically, a tetragonal structure phase), and the main crystalline phase of the second dielectric layer 2 is at least one of a tetragonal structure phase or an orthorhombic structure phase (specifically, a tetragonal structure phase).

In this embodiment, taking zirconium oxide as an example for the first dielectric layer 1 and hafnium oxide as an example for the second dielectric layer 2, the growth of zirconium oxide and hafnium oxide (ZrHf) is performed first. Hafnium oxide can undergo epitaxial growth based on the crystallization of zirconium oxide, thereby reducing the energy required for hafnium oxide crystallization and facilitating the formation of the tetragonal structure phase. A barrier layer (e.g., aluminum oxide), composed of elements with a high bandgap, is formed on the stacked layer. On the one hand, this can reduce leakage paths, and on the other hand, doping of the barrier layer (e.g., aluminum) can prevent the growth of ZrHf crystalline grains. Hafnium oxide and zirconium oxide (HfZr) are continuously grown on the barrier layer (e.g., aluminum oxide). The HfAlHf interface exhibits excellent resistance to leakage current because the bandgap hierarchy is: aluminum oxide > hafnium oxide > zirconium oxide. However, compared to zirconium oxide, both hafnium oxide and aluminum oxide are more difficult to crystallize. As a result, no orthorhombic structure phase (O phase) forms near the aluminum oxide, with the tetragonal structure phase (T phase) being predominant (90% to 95%), along with the presence of a small amount of cubic structure phase (C phase) and monoclinic phase (M phase). The dielectric constant of the capacitor dielectric layer in this embodiment is 35 to 37. Under a voltage range of -0.6 V to 0.6 V, the leakage current ranges from -1e⁻⁵ pA to 1e⁻⁵ pA/cell.

In one embodiment of the present disclosure, as shown in FIG. 5, the capacitor dielectric layer 3000 includes a first stacked layer 100, a barrier layer 400, a first stacked layer 100, and a barrier layer 400, which are stacked along the first direction Z. As shown in FIG. 6, the first stacked layer 100 includes at least one first unit 10 stacked along the first direction Z. The first unit 10 includes a first dielectric layer 1, a second dielectric layer 2, and a first dielectric layer 1, which are stacked along the first direction Z. The thickness ratio between the two first stacked layers 100 is (0.4-2.5): 1. The thickness of each barrier layer is 0.07 nm to 0.4 nm, and the total thickness of the capacitor dielectric layer is 5 nm to 9 nm. The respective parameter range of the first stacked layer ZₐH_{b}(Z₂ₐH_{b})c₁₋₁Zₐ is as previously described. The main crystalline phase of the first dielectric layer 1 is at least one of a tetragonal structure phase or an orthorhombic structure phase (specifically, a tetragonal structure phase), and the main crystalline phase of the second dielectric layer 2 is at least one of a tetragonal structure phase or an orthorhombic structure phase (specifically, a tetragonal structure phase).

In this embodiment, taking zirconium oxide as an example for the first dielectric layer 1 and hafnium oxide as an example for the second dielectric layer 2, the combination of zirconium oxide, hafnium oxide, and zirconium oxide (ZHZ) has two main effects. On the one hand, the combination allows hafnium oxide to undergo epitaxial growth on zirconium oxide. On the other hand, hafnium oxide also has a certain inhibitory effect on the subsequent crystallization of zirconium oxide, increasing the crystallization surface energy of zirconium oxide. When zirconium oxide reaches a certain thickness, it can achieve the tetragonal structure phase of zirconium oxide-hafnium oxide (ZrHfO). A barrier layer (e.g., aluminum oxide), composed of elements with a high bandgap, is formed on the stacked layer. On the one hand, this can reduce leakage paths, and on the other hand, doping of the barrier layer (e.g., aluminum) can prevent the growth of ZrHf crystalline grains. However, the combination of zirconium oxide, hafnium oxide, and zirconium oxide (ZHZ) needs to overcome relatively high surface energy for crystallization. Additionally, the interfaces are relatively numerous, which is not beneficial for leakage performance. The tetragonal structure phase (T phase) is predominant (90% to 95%), along with the presence of a small amount of cubic structure phase (C phase) and monoclinic phase (M phase). The dielectric constant of the capacitor dielectric layer in this embodiment is 37 to 39. Under a voltage range of -0.6 V to 0.6 V, the leakage current ranges from -2e⁻⁵ pA to 2e⁻⁵ pA/cell.

In the related art, the capacitor dielectric layer includes a stacked first zirconium oxide layer, hafnium oxide layer, and second zirconium oxide layer, as well as an aluminum oxide layer and a third zirconium oxide layer. The first zirconium oxide layer, the hafnium oxide layer, and the second zirconium oxide layer all have a tetragonal structure phase, while the aluminum oxide layer and the third zirconium oxide layer are amorphous. The first zirconium oxide layer and the second zirconium oxide layer each independently have a thickness of 0.5 nm to 3 nm, the hafnium oxide layer has a thickness of 0.5 nm to 1.8 nm, the aluminum oxide layer has a thickness of 0.2 nm, and the third zirconium oxide layer has a thickness of 0.3 nm to 1 nm. The entire capacitor dielectric layer has a thickness of 2 nm to 6 nm. In this capacitor dielectric layer, the proportion of the tetragonal structure phase is at most 75%, and the dielectric constant is at most 33. Under a voltage range of -0.6 V to 0.6 V, the leakage current ranges from -5e⁻⁵ pA to 5e⁻⁵ pA/cell.

According to a second aspect of the embodiments of the present disclosure, a capacitor structure is provided. The capacitor structure includes a first electrode layer, a second electrode layer, and the capacitor dielectric layer as described in any one of the foregoing embodiments. Moreover, the capacitor dielectric layer is disposed between the first electrode layer and the second electrode layer.

In some embodiments, the capacitor includes planar, cup-shaped, cylindrical, or pillar-shaped capacitors.

In some embodiments, each of the first electrode layer and the second electrode layer may include metal, metal carbide, metal nitride, or conductive oxide. In some embodiments, each of the first electrode layer and the second electrode layer may, for example, include polycrystalline silicon and may further include, but is not limited to, metal materials such as titanium (Ti), cobalt (Co), tungsten (W), titanium nitride (TiN), tungsten nitride (WN), titanium tungsten (TiW), titanium aluminum (TiAl), and titanium aluminum nitride (TiAlN), as well as combinations thereof. In some embodiments, the materials of the first electrode layer and the second electrode layer may be the same or may differ from one another.

In the capacitor dielectric layer, the second dielectric layer (e.g., hafnium oxide layer), which has a main crystalline phase of at least one of the tetragonal structure phase and the orthorhombic structure phase, may be made of a ferroelectric material that exhibits ferroelectric properties or antiferroelectric properties depending on the electric field. By using the second dielectric layer (e.g., the hafnium oxide layer) with ferroelectric properties or antiferroelectric properties, the dielectric constant value of the stacked structure is increased. Such a stacked structure can satisfy the requirement for a high dielectric constant and lower leakage current (particularly when aided by a barrier layer), for example, satisfying the requirement of the capacitor for a high capacitance value and low leakage current.

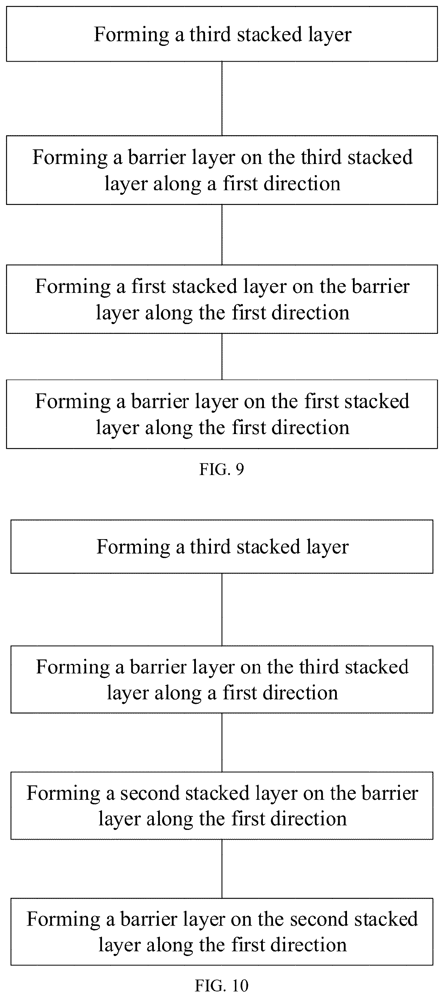

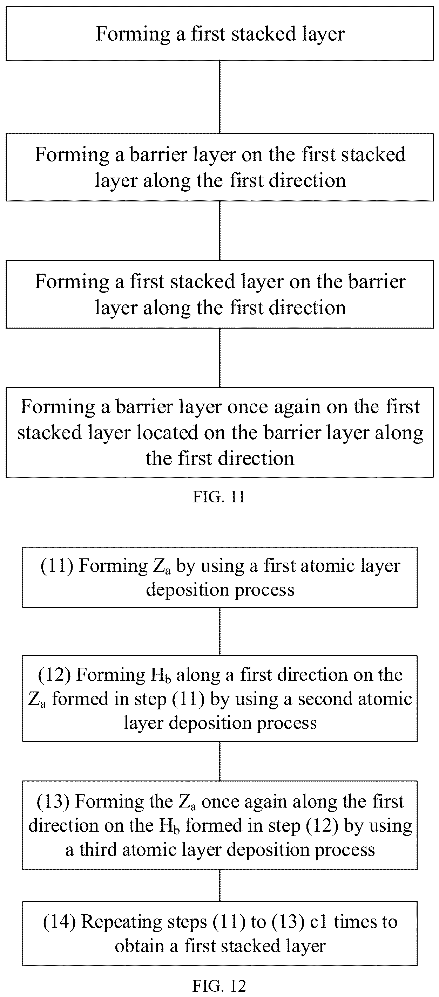

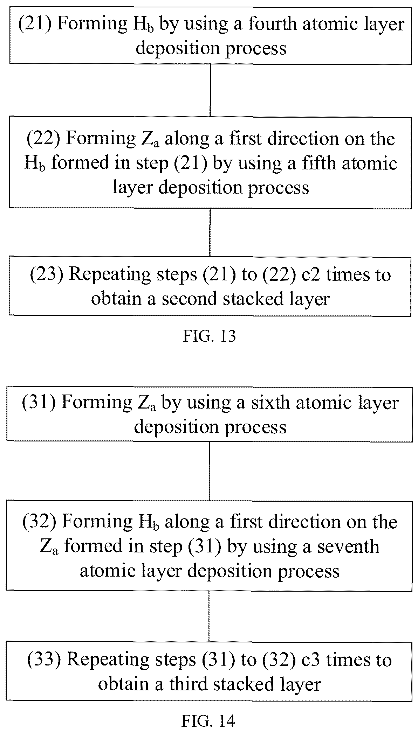

FIG. 9 is a schematic diagram of a process for manufacturing the capacitor dielectric layer shown in FIG. 3 according to the present disclosure; FIG. 10 is a schematic diagram of a process for manufacturing the capacitor dielectric layer shown in FIG. 4 according to the present disclosure; FIG. 11 is a schematic diagram of a process for manufacturing the capacitor dielectric layer shown in FIG. 5 according to the present disclosure; FIG. 12 is a schematic diagram of a process for manufacturing the first stacked layer shown in FIG. 6 according to the present disclosure; FIG. 13 is a schematic diagram of a process for manufacturing the second stacked layer shown in FIG. 7 according to the present disclosure; and FIG. 14 is a schematic diagram of a process for manufacturing the third stacked layer shown in FIG. 8 according to the present disclosure. The process for manufacturing the capacitor dielectric layer will be described below with reference to FIGS. 9 to 14.

According to a third aspect of the embodiments of the present disclosure, as shown in FIGS. 9 to 14, a method for manufacturing a capacitor dielectric layer is provided. The manufacturing method includes forming any at least two stacked layers among a first stacked layer, a second stacked layer, and a third stacked layer, which are stacked along the first direction.

The first stacked layer includes at least one first unit stacked along the first direction, the second stacked layer includes at least one second unit stacked along the first direction, and the third stacked layer includes at least one third unit stacked along the first direction; the first unit includes a first dielectric layer, a second dielectric layer, and a first dielectric layer, which are stacked along the first direction; the second unit includes the second dielectric layer and the first dielectric layer, which are stacked along the first direction; the third unit includes the first dielectric layer and the second dielectric layer, which are stacked along the first direction. The main crystalline phase of the first dielectric layer is at least one of the tetragonal structure phase and the orthorhombic structure phase, and the main crystalline phase of the second dielectric layer is at least one of the tetragonal structure phase and the orthorhombic structure phase.

In the manufacturing method according to the embodiments of the present disclosure, the interpretation of relevant terms or phrases, the structure and thickness of each stacked layer, the material selection for each film layer, the relevant functions and mechanisms, etc., can all be referred to in the relevant descriptions of the capacitor dielectric layer in the first aspect of the embodiments of the present disclosure, which will not be detailed here again.

In the embodiments of the present disclosure, the manufacturing method further includes forming a barrier layer, which is formed on each of the first stacked layer, the second stacked layer, and the third stacked layer.

The following takes the manufacturing processes of three capacitor dielectric layers, which exhibit significantly higher dielectric constants and significantly lower leakage currents as described in the first aspect of the embodiments of the present disclosure, as examples to specifically explain the method for manufacturing a capacitor dielectric layer in the third aspect of the embodiments of the present disclosure.

In one embodiment of the present disclosure, as shown in FIG. 9, the manufacturing method includes: forming the third stacked layer, the barrier layer, the first stacked layer, and the barrier layer stacked along the first direction. Specifically, the method includes the following steps.

In S91, a third stacked layer is formed.

In S92, a barrier layer is formed on the third stacked layer along the first direction.

In S93, a first stacked layer is formed on the barrier layer along the first direction.

In S94, a barrier layer is formed on the first stacked layer along the first direction.

In another embodiment of the present disclosure, as shown in FIG. 10, the manufacturing method includes: forming the third stacked layer, the barrier layer, the second stacked layer, and the barrier layer stacked along the first direction. Specifically, the method includes the following steps.

In S101, a third stacked layer is formed.

In S102, a barrier layer is formed on the third stacked layer along the first direction.

In S103, a second stacked layer is formed on the barrier layer along the first direction.

In S104, a barrier layer is formed on the second stacked layer along the first direction.

In another embodiment of the present disclosure, as shown in FIG. 11, the manufacturing method includes: forming the first stacked layer, the barrier layer, the first stacked layer, and the barrier layer stacked along the first direction. Specifically, the method includes the following steps.

In S111, a first stacked layer is formed.

In S112, a barrier layer is formed on the first stacked layer along the first direction.

In S113, a first stacked layer is formed on the barrier layer along the first direction.

S114, a barrier layer is formed once again on the first stacked layer located on the barrier layer along the first direction.

In the embodiments of the present disclosure, forming the any at least two stacked layers among a first stacked layer, a second stacked layer, and a third stacked layer, which are stacked along the first direction includes: forming any two stacked layers among the first stacked layer, the second stacked layer, and the third stacked layer, which are stacked along the first direction. The thickness ratio range of the two stacked layers is (0.4-2.5): 1.

In the embodiments of the present disclosure, forming the first stacked layer includes: forming at least one first unit stacked along the first direction. Forming the first unit includes: forming the first dielectric layer, the second dielectric layer, and the first dielectric layer stacked along the first direction.

In the embodiments of the present disclosure, forming the second stacked layer includes: forming at least one second unit stacked along the first direction. Forming the second unit includes: forming the second dielectric layer and the first dielectric layer stacked along the first direction.

In the embodiments of the present disclosure, forming the third stacked layer includes: forming at least one third unit stacked along the first direction. Forming the third unit includes: forming the first dielectric layer and the second dielectric layer stacked along the first direction.

In the embodiments of the present disclosure, Zₐ represents a first dielectric layer with a first thickness a, Z₂ₐ represents a first dielectric layer with a second thickness 2a, and the Z₂ₐ represents two Zₐ stacked along the first direction; H_{b} represents a second dielectric layer with a third thickness b.

As shown in FIG. 12, forming the first stacked layer includes the following steps.
(11) The Zₐ is formed by using a first atomic layer deposition process. The process of forming the Zₐ by using the first atomic layer deposition process includes a1 first sub-dielectric layer growth cycles which are cyclically performed. After completing each first sub-dielectric layer growth cycle, a first sub-dielectric layer is formed, and a1 such first sub-dielectric layers constitute the Zₐ.
(12) The H_{b} is formed along the first direction on the Zₐ formed in step (11) by using a second atomic layer deposition process. The process of forming the H_{b} by using the second atomic layer deposition process includes b1 second sub-dielectric layer growth cycles which are cyclically performed. After completing each second sub-dielectric layer growth cycle, a second sub-dielectric layer is formed, and b1 such second sub-dielectric layers constitute the H_{b}.
(13) The Zₐ is formed once again along the first direction on the H_{b} formed in step (12) by using a third atomic layer deposition process. The process of forming the Zₐ by using the third atomic layer deposition process includes a1 first sub-dielectric layer growth cycles which are cyclically performed. After completing each first sub-dielectric layer growth cycle, a first sub-dielectric layer is formed, and a1 such first sub-dielectric layers constitute the Zₐ. The Zₐ, the H_{b}, and the Zₐ, which are formed along the first direction and arranged in a stacked manner, constitute one first unit.
(14) Steps (11) to (13) are repeated c1 times to obtain the first stacked layer, where a1, b1, and c1 satisfy: 1 ≤ a1/b1 ≤ 20, the c1 represents the number of the first units in the first stacked layer, the c1 is a positive integer and satisfies 1 ≤ c1 ≤ 30, and 30 ≤ (2a1 + b1) * c1 ≤ 60; as well as satisfy: the first stacked layer is represented as ZₐH_{b}(Z₂ₐH_{b})_{c1-1}Zₐ. In the first stacked layer, the Zₐ, the H_{b}, (c1-1) sub-stacked structures composed of the Z₂ₐ and the H_{b}, and the Zₐ are stacked along the first direction. In the sub-stacked structure, the Z₂ₐ and the H_{b} are stacked along the first direction. The total thickness of the first stacked layer is 2.4 nm to 6 nm, and 1 ≤ a/b ≤ 20.

Exemplarily, forming the first stacked layer includes the following steps.

TiN is used as the lower electrode layer, and to ensure that uniform atomic layer deposition can be performed for the high dielectric constant capacitor dielectric layer, ozone is used to treat the TiN surface. Taking the example where the material of the first dielectric layer includes zirconium oxide and the material of the second dielectric layer includes hafnium oxide, both the zirconium oxide layer and the hafnium oxide layer are formed using atomic layer deposition technology. This process involves using a source gas containing Zr and Hf, which undergoes chemical and physical adsorption on the TiN lower electrode layer. Any excess source gas that cannot be adsorbed is blown away using inert Ar gas. Ozone is used as a reaction gas to break the chemical bonds of the source gas and form an oxide. Any unreacted gas is then blown away with Ar gas. This completes one growth cycle. First, atomic layer deposition of zirconium oxide is performed for a1 growth cycles. Then, atomic layer deposition of hafnium oxide is performed for b1 growth cycles on top of the zirconium oxide. On the basis of the zirconium oxide-hafnium oxide (ZₐH_{b}), the same atomic layer deposition of zirconium oxide is again performed for a1 growth cycles. ZₐH_{b}Zₐ is considered as one cycle, and this cycle may be repeated c1 times as a whole. The bottom-layer zirconium oxide serves as the nucleation phase. On the basis of nucleation from the bottom-layer zirconium oxide, hafnium oxide continues to nucleate. After reaching a certain thickness, hafnium oxide can crystallize. If zirconium oxide is further deposited, the surface energy of ZH can be effectively reduced, thus reducing the formation of the monoclinic crystalline phase (M-phase) and increasing the likelihood of forming the tetragonal structure phase (T-phase). As a result, the dielectric constant is increased. (Defining 1 ≤ a1/b1 ≤ 20, 1 ≤ c1 ≤ 30, and 30 ≤ (2a1 + b1) * c1 ≤ 60 ensures sufficient crystallization of hafnium oxide in ZₐH_{b}Zₐ, thereby achieving a higher dielectric constant).

As shown in FIG. 13, forming the second stacked layer includes the following steps.
(21) The H_{b} is formed by using a fourth atomic layer deposition process. The process of forming the H_{b} by using the fourth atomic layer deposition process includes b2 second sub-dielectric layer growth cycles which are cyclically performed. After completing each second sub-dielectric layer growth cycle, a second sub-dielectric layer is formed, and b2 second sub-dielectric layers constitute the H_{b}.
(22) The Zₐ is formed along the first direction on the H_{b} formed in step (21) by using a fifth atomic layer deposition process. The process of forming the Zₐ by using the fifth atomic layer deposition process includes a2 first sub-dielectric layer growth cycles which are cyclically performed. After completing each first sub-dielectric layer growth cycle, a first sub-dielectric layer is formed, and a2 first sub-dielectric layers constitute the Zₐ. The H_{b} and the Zₐ, which are formed along the first direction and arranged in a stacked manner, constitute one second unit.
(23) Steps (21) to (22) are repeated c2 times to obtain the second stacked layer, where a2, b2, and c2 satisfy: 1 ≤ a2/b2 ≤ 20, c2 represents the number of second units in the second stacked layer, the c2 is a positive integer and satisfies 1 ≤ c2 ≤ 50, and 30 ≤ (a2 + b2) * c2 ≤ 60; as well as satisfy: the second stacked layer is represented as (H_{b}Zₐ)_{c2}. In the second stacked layer, c2 second units are stacked along the first direction, the total thickness of the second stacked layer is 2.4 nm to 6 nm, and 1 ≤ a/b ≤ 20.

Exemplarily, forming the second stacked layer includes the following steps.

TiN is used as the lower electrode layer, and to ensure that uniform atomic layer deposition can be performed for the high dielectric constant capacitor dielectric layer, ozone is used to treat the TiN surface. Taking the example where the material of the first dielectric layer includes zirconium oxide and the material of the second dielectric layer includes hafnium oxide, both the zirconium oxide layer and the hafnium oxide layer are formed using atomic layer deposition technology. This process involves using a source gas containing Zr and Hf, which undergoes chemical and physical adsorption on the TiN lower electrode layer. Any excess source gas that cannot be adsorbed is blown away using inert Ar gas. Ozone is used as a reaction gas to break the chemical bonds of the source gas and form an oxide. Any unreacted gas is then blown away with Ar gas. This completes one growth cycle. First, atomic layer deposition of hafnium oxide is performed for b2 growth cycles. Then, atomic layer deposition of zirconium oxide is performed for a2 growth cycles on top of the hafnium oxide. H_{b}Zₐ is considered as one cycle, and this cycle may be repeated c2 times as a whole. The bottom-layer hafnium oxide, serving as the substrate, does not crystallize. Zirconium oxide, when deposited on hafnium oxide to a certain thickness, will spontaneously crystallize and induce nucleation and crystallization of hafnium oxide. Therefore, the (H_{b}Zₐ)_{c2} exhibits good crystallization consistency. (Defining 1 ≤ a2/b2 ≤ 20, 1 ≤ c2 ≤ 50, and 30 ≤ (a2 + b2) * c2 ≤ 60 allows for excellent control over the crystallization degree of hafnium oxide, thereby achieving a higher dielectric constant).

As shown in FIG. 14, forming the third stacked layer includes the following steps.
(31) The Zₐ is formed by using a sixth atomic layer deposition process. The process of forming the Zₐ by using the sixth atomic layer deposition process includes a3 first sub-dielectric layer growth cycles which are cyclically performed. After completing each first sub-dielectric layer growth cycle, a first sub-dielectric layer is formed, and a3 first sub-dielectric layers constitute the Zₐ.
(32) The H_{b} is formed along the first direction on the Zₐ formed in step (31) by using a seventh atomic layer deposition process. The process of forming the H_{b} by using the seventh atomic layer deposition process includes b3 second sub-dielectric layer growth cycles which are cyclically performed. After completing each second sub-dielectric layer growth cycle, a second sub-dielectric layer is formed, and b3 second sub-dielectric layers constitute the H_{b}. The Zₐ and the H_{b}, which are formed along the first direction and arranged in a stacked manner, constitute one third unit.
(33) Steps (31) to (32) are repeated c3 times to obtain the third stacked layer, where a3, b3, and c3 satisfy: 1 ≤ a3/b3 ≤ 20, the c3 represents the number of the third unit in the third stacked layer, the c3 is a positive integer and satisfies 1 ≤ c3 ≤ 50, and 30 ≤ (a3 + b3) * c3 ≤ 60; as well as satisfy: the third stacked layer is represented as (ZₐH_{b})_{c3}. In the third stacked layer, c3 third units are stacked along the first direction, the total thickness of the third stacked layer is 2.4 nm to 6 nm, and 1 ≤ a/b ≤ 20.

Exemplarily, forming the third stacked layer includes the following steps.

TiN is used as the lower electrode layer, and to ensure that uniform atomic layer deposition can be performed for the high dielectric constant capacitor dielectric layer, ozone is used to treat the TiN surface. Taking the example where the material of the first dielectric layer includes zirconium oxide and the material of the second dielectric layer includes hafnium oxide, both the zirconium oxide layer and the hafnium oxide layer are formed using atomic layer deposition technology. This process involves using a source gas containing Zr and Hf, which undergoes chemical and physical adsorption on the TiN lower electrode layer. Any excess source gas that cannot be adsorbed is blown away using inert Ar gas. Ozone is used as a reaction gas to break the chemical bonds of the source gas and form an oxide. Any unreacted gas is then blown away with Ar gas. This completes one growth cycle. First, atomic layer deposition of zirconium oxide is performed for a3 growth cycles. Then, atomic layer deposition of hafnium oxide is performed for b3 growth cycles on top of the zirconium oxide. ZₐH_{b} is considered as one cycle, and this cycle may be repeated c3 times as a whole. (Defining 1 ≤ a3/b3 ≤ 20, 1 ≤ c3 ≤ 50, and 30 ≤ (a3 + b3) * c3 ≤ 60 allows for excellent control over the crystallization degree of hafnium oxide, thereby achieving a higher dielectric constant).

In the embodiments of the present disclosure, the process temperature for forming the first sub-dielectric layer ranges from 260 °C to 350 °C, and the pressure used ranges from 0.5 torr to 2.5 torr. The process temperature for forming the second sub-dielectric layer ranges from 260°C to 350°C, and the pressure used ranges from 0.5 torr to 2.5 torr. That is, the process steps for forming the first dielectric layer and the second dielectric layer in the embodiments of the present disclosure can all be carried out under low-temperature conditions, thereby helping to ensure stable growth and good performance of both the first dielectric layer and the second dielectric layer.

In some embodiments, the material of the first dielectric layer includes zirconium oxide, and the material of the second dielectric layer includes hafnium oxide. The gas source used to form the first dielectric layer includes: (cyclopentadienyl)tris(dimethylamido)zirconium (CpZr(NMe₂)₃) and ozone. The gas source used to form the second dielectric layer includes: (cyclopentadienyl)tris(dimethylamido)hafnium (also known as cyclopentadienyltris(dimethylamino)hafnium, tris(dimethylamino)cyclopentadienylhafnium, or (cyclopentadienyl)tris(dimethylamido)hafnium CpHf(NMe₂)₃) and ozone.

Since zirconium oxide and hafnium oxide are oxides of elements from the same group and share similar structures, the zirconium oxide layer acts as a "seed" during the crystallization of the hafnium oxide layer. This accelerates the crystallization process of the hafnium oxide layer and improves the phase transition rate.

Additionally, there is a difference in lattice constants between zirconium oxide and hafnium oxide. By forming the hafnium oxide layer on the zirconium oxide layer using an epitaxial growth process, a transition region with lattice constant mismatch is created at the contact surface between the zirconium oxide layer and the hafnium oxide layer. The transition region introduces strain, which is equivalent to the zirconium oxide layer and the hafnium oxide layer exerting stress on each other through the transition region. The presence of this stress causes the hafnium oxide layer to deposit as a thin film with a tetragonal structure phase within a specific thickness range. Consequently, the dielectric constant K value of the resulting capacitor dielectric layer is improved.

In the embodiments of the present disclosure, forming the barrier layer includes: forming the barrier layer by using an eighth atomic layer deposition process. The process of forming the barrier layer by using the eighth atomic layer deposition process includes d1 sub-barrier layer growth cycles which are cyclically performed. After completing each sub-barrier layer growth cycle, a sub-barrier layer is formed, and d1 such sub-barrier layers constitute the barrier layer. d1 ranges from 1 to 4, and the thickness satisfying the barrier layer ranges from 0.07 nm to 0.4 nm.

In the embodiments of the present disclosure, the process temperature for forming the sub-barrier layer ranges from 250°C to 400°C, and the pressure used ranges from 0.5 torr to 2.5 torr.

Here, the explanation is provided using aluminum oxide as an example of the barrier layer. The gas source used for forming the barrier layer includes: trimethylaluminum (TMA) and ozone. The temperature for forming the barrier layer ranges from 250 °C to 400 °C, and the pressure used ranges from 0.5 Torr to 2.5 Torr. Under the aforementioned conditions, the aluminum oxide layer can be formed in a manner that facilitates its uniform and stable growth. The aluminum oxide layer plays a primary role in reducing the leakage current of the capacitor dielectric layer.

In the embodiments of the present disclosure, the total thickness of the manufactured capacitor dielectric layer may range from 5 nm to 9 nm.

The capacitor dielectric layer manufactured by the method for manufacturing a capacitor dielectric layer according to the third aspect of the embodiments of the present disclosure shares the same structure with the capacitor dielectric layer according to the first aspect of the embodiments of the present disclosure. For technical features not exhaustively disclosed in the embodiments of the present disclosure, please refer to the above-described embodiments for understanding, which will not be detailed here again.

The capacitor structure according to the second aspect of the embodiments of the present disclosure can be manufactured, based on the capacitor dielectric layer according to the first aspect of the embodiments of the present disclosure, by using conventional methods for manufacturing capacitor structures in the field, which will not be detailed here.

The capacitor dielectric layer and the capacitor structure according to the embodiments of the present disclosure can be used for manufacturing a memory. That is, the embodiments of the present disclosure can further provide a memory, which includes the capacitor structure as described in any one of the foregoing embodiments.

In some embodiments, the memory according to the embodiments of the present disclosure includes various types of memory, for example, NAND flash memory (Flash), NOR flash memory, dynamic random access memory (DRAM), static random access memory (Static Random Access Memory, SRAM), phase-change memory (Phase-Change Memory, PCM), ferroelectric random access memory (Ferroelectric Random Access Memory, FRAM), magnetic random access memory (Magnetic Random Access Memory, MRAM), or resistive random access memory (Resistive Random Access Memory, RRAM).

In some embodiments, the memory according to the embodiments of the present disclosure can be used in electronic devices with storage functionality. The electronic device may be a terminal device, e.g., a mobile phone, a tablet computer, a smart bracelet, a personal computer (PC), a server, a workstation, or the like. The storage functionality in the electronic device can be implemented using the aforementioned corresponding memory.

In the above descriptions, detailed explanations of techniques such as the patterning and etching of various layers are not provided. However, those skilled in the art should understand that layers, regions, etc. with desired shapes can be formed through various technical means. In addition, to form the same structure, those skilled in the art may also devise methods that are not entirely identical to the methods described above. In addition, although the various embodiments are described separately above, this does not imply that the measures in each embodiment cannot be advantageously combined.

It should be understood that reference throughout this specification to "one embodiment" or "an embodiment" means that a particular feature, structure, or characteristic described in connection with the embodiment is included in at least one embodiment of the present disclosure. Therefore, the appearances of the phrases "in one embodiment" or "in an embodiment" in various places throughout this specification do not necessarily all refer to the same embodiment. Furthermore, these particular features, structures, or characteristics may be combined in any suitable manner in one or more embodiments. It should be understood that, in various embodiments of the present disclosure, the sequence numbers of the processes described above do not imply an order of execution, and the order of execution of the processes should be determined by their functions and inherent logic, and these sequence numbers should not constitute any limitation to the implementation process of the embodiments of the present disclosure. The serial numbers of the embodiments of the present disclosure described above are for the purpose of describing only and do not represent the superiority or inferiority of the embodiments.

The methods disclosed in the method embodiments provided in the present disclosure may be combined in any manner without conflict to obtain new method embodiments.

The above description is only the specific embodiments of the present disclosure, but the protection scope of the present disclosure is not limited thereto; changes or substitutions that any of those skilled in the art can easily think of within the technical scope disclosed by the present disclosure shall all fall within the protection scope of the present disclosure. Therefore, the protection scope of the present disclosure shall be subject to the protection scope of the claims.

## Claims

1. A capacitor dielectric layer, comprising any at least two stacked layers among a first stacked layer, a second stacked layer, and a third stacked layer, which are stacked along a first direction, wherein the first stacked layer comprises at least one first unit stacked along the first direction, the second stacked layer comprises at least one second unit stacked along the first direction, and the third stacked layer comprises at least one third unit stacked along the first direction; the first unit comprises a first dielectric layer, a second dielectric layer, and a first dielectric layer, which are stacked along the first direction; the second unit comprises the second dielectric layer and the first dielectric layer, which are stacked along the first direction; the third unit comprises the first dielectric layer and the second dielectric layer, which are stacked along the first direction; a main crystalline phase of the first dielectric layer is at least one of a tetragonal structure phase and an orthorhombic structure phase, and a main crystalline phase of the second dielectric layer is at least one of the tetragonal structure phase and the orthorhombic structure phase.

2. The capacitor dielectric layer according to claim 1, further comprising a barrier layer, wherein the barrier layer is disposed on each of the first stacked layer, the second stacked layer, and the third stacked layer.

3. The capacitor dielectric layer according to claim 2, wherein the capacitor dielectric layer comprises the third stacked layer, the barrier layer, the first stacked layer, and the barrier layer, which are stacked along the first direction; or
the capacitor dielectric layer comprises the third stacked layer, the barrier layer, the second stacked layer, and the barrier layer stacked along the first direction; or
the capacitor dielectric layer comprises the first stacked layer, the barrier layer, the first stacked layer, and the barrier layer stacked along the first direction.

4. The capacitor dielectric layer according to any one of claims 1 to 3, comprising any two stacked layers among the first stacked layer, the second stacked layer, and the third stacked layer, which are stacked along the first direction, wherein a thickness ratio range of the two stacked layers is (0.4-2.5): 1.

5. The capacitor dielectric layer according to any one of claims 1 to 3, wherein Zₐ represents a first dielectric layer with a first thickness a, Z₂ₐ represents a first dielectric layer with a second thickness 2a, and the Z₂ₐ represents two of the Zₐ stacked along the first direction; H_{b} represents a second dielectric layer with a third thickness b, wherein
the first stacked layer is represented as ZₐH_{b}(Z₂ₐH_{b})_{c1-1}Zₐ; in the first stacked layer, the Zₐ, the H_{b}, (c1-1) sub-stacked structures composed of the Z₂ₐ and the H_{b}, and the Zₐ are stacked along the first direction; in each of the (c1-1) sub-stacked structures, the Z₂ₐ and the H_{b} are stacked along the first direction; a total thickness of the first stacked layer is 2.4 nm to 6 nm, and 1 ≤ a/b ≤ 20; the c1 represents a number of the first unit in the first stacked layer; the first unit is represented by a first stacked structure composed of Zₐ, H_{b}, and Zₐ stacked along the first direction; the c1 is a positive integer and satisfies 1 ≤ c1 ≤ 30; and/or,
the second stacked layer is represented as (H_{b}Zₐ)_{c2}; in the second stacked layer, c2 second units are stacked along the first direction; the second unit is represented by a second stacked structure composed of H_{b} and Zₐ stacked along the first direction; a total thickness of the second stacked layer is 2.4 nm to 6 nm, and 1 ≤ a/b ≤ 20; the c2 is a positive integer and satisfies 1 ≤ c2 ≤ 50; and/or,
the third stacked layer is represented as (ZₐH_{b})_{c3}; in the third stacked layer, c3 third units are stacked along the first direction; the third unit is represented by a third stacked structure composed of Zₐ and H_{b} stacked along the first direction; a total thickness of the third stacked layer is 2.4 nm to 6 nm, and 1 ≤ a/b ≤ 20; the c3 is a positive integer and satisfies 1 ≤ c3 ≤ 50.

6. The capacitor dielectric layer according to claim 2 or 3, wherein the barrier layer has a thickness of 0.07 nm to 0.4 nm.

7. The capacitor dielectric layer according to any one of claims 1 to 3, wherein a total thickness of the capacitor dielectric layer is 5 nm to 9 nm.

8. The capacitor dielectric layer according to claim 2 or 3, wherein a material of the first dielectric layer comprises zirconium oxide; and/or,
a material of the second dielectric layer comprises at least one of hafnium oxide, titanium oxide, niobium oxide, yttrium oxide, lanthanum oxide, and tantalum oxide; and/or,
a material of the barrier layer comprises at least one of aluminum oxide, silicon oxide, niobium oxide, silicon-doped niobium oxide, silicon-doped hafnium oxide, and lanthanum oxide; a bandgap of the barrier layer is greater than a bandgap of the first dielectric layer, and the bandgap of the barrier layer is greater than a bandgap of the second dielectric layer.

9. A capacitor structure, comprising a first electrode layer, a second electrode layer, and the capacitor dielectric layer according to any one of claims 1 to 8, wherein the capacitor dielectric layer is disposed between the first electrode layer and the second electrode layer.

10. A method for manufacturing a capacitor dielectric layer, comprising: forming any at least two stacked layers among a first stacked layer, a second stacked layer, and a third stacked layer, which are stacked along a first direction, wherein
the first stacked layer comprises at least one first unit stacked along the first direction, the second stacked layer comprises at least one second unit stacked along the first direction, and the third stacked layer comprises at least one third unit stacked along the first direction; the first unit comprises a first dielectric layer, a second dielectric layer, and a first dielectric layer, which are stacked along the first direction; the second unit comprises the second dielectric layer and the first dielectric layer, which are stacked along the first direction; the third unit comprises the first dielectric layer and the second dielectric layer, which are stacked along the first direction; a main crystalline phase of the first dielectric layer is at least one of a tetragonal structure phase and an orthorhombic structure phase, and a main crystalline phase of the second dielectric layer is at least one of the tetragonal structure phase and the orthorhombic structure phase.

11. The method according to claim 10, further comprising: forming a barrier layer, wherein the barrier layer is formed on each of the first stacked layer, the second stacked layer, and the third stacked layer.

12. The method according to claim 11, further comprising:
forming the third stacked layer, the barrier layer, the first stacked layer, and the barrier layer stacked along the first direction; or
forming the third stacked layer, the barrier layer, the second stacked layer, and the barrier layer stacked along the first direction; or
forming the first stacked layer, the barrier layer, the first stacked layer, and the barrier layer stacked along the first direction.

13. The method according to any one of claims 10 to 12, wherein forming the any at least two stacked layers among the first stacked layer, the second stacked layer, and the third stacked layer, which are stacked along the first direction comprises: forming any two stacked layers among the first stacked layer, the second stacked layer, and the third stacked layer, which are stacked along the first direction, a thickness ratio range of the two stacked layers being (0.4-2.5):1.

14. The method according to any one of claims 10 to 12, wherein Zₐ represents a first dielectric layer with a first thickness a, Z₂ₐ represents a first dielectric layer with a second thickness 2a, and the Z₂ₐ represents two of the Zₐ stacked along the first direction; H_{b} represents a second dielectric layer with a third thickness b, wherein
forming the first stacked layer comprises:
(11) forming the Zₐ by using a first atomic layer deposition process, wherein a process of forming the Zₐ by using the first atomic layer deposition process comprises a1 first sub-dielectric layer growth cycles which are cyclically performed; after completing each of the a1 first sub-dielectric layer growth cycles, a first sub-dielectric layer is formed, and a1 first sub-dielectric layers constitute the Zₐ;
(12) forming the H_{b} along the first direction on the Zₐ formed in step (11) by using a second atomic layer deposition process, wherein a process of forming the H_{b} by using the second atomic layer deposition process comprises b1 second sub-dielectric layer growth cycles which are cyclically performed; after completing each of the b1 second sub-dielectric layer growth cycles, a second sub-dielectric layer is formed, and b1 second sub-dielectric layers constitute the H_{b};
(13) forming the Zₐ once again along the first direction on the H_{b} formed in step (12) by using a third atomic layer deposition process, wherein a process of forming the Zₐ by using the third atomic layer deposition process comprises a1 first sub-dielectric layer growth cycles which are cyclically performed; after completing each of the a1 first sub-dielectric layer growth cycles, the first sub-dielectric layer is formed, and a1 first sub-dielectric layers constitute the Zₐ; the Zₐ, the H_{b}, and the Zₐ, which are formed along the first direction and stacked, constitute one first unit; and
(14) repeating steps (11) to (13) c1 times to obtain the first stacked layer, wherein a1, b1, and c1 satisfy: 1 ≤ a1/b1 ≤ 20, the c1 represents a number of the first unit in the first stacked layer, the c1 is a positive integer and satisfies 1 ≤ c1 ≤ 30, and 30 ≤ (2a1 + b1) * c1 ≤ 60; as well as satisfy: the first stacked layer is represented as ZₐHₑ(Z₂ₐH_{b})_{c1-1}Zₐ; in the first stacked layer, the Zₐ, the H_{b}, (c1-1) sub-stacked structures composed of the Z₂ₐ and the H_{b}, and the Zₐ are stacked along the first direction; in each of the (c1-1) sub-stacked structures, the Z₂ₐ and the H_{b} are stacked along the first direction; a total thickness of the first stacked layer is 2.4 nm to 6 nm, and 1 ≤ a/b ≤ 20; and/or,
forming the second stacked layer comprises:
(21) forming the H_{b} by using a fourth atomic layer deposition process, wherein a process of forming the H_{b} by using the fourth atomic layer deposition process comprises b2 second sub-dielectric layer growth cycles which are cyclically performed; after completing each of the b2 second sub-dielectric layer growth cycles, a second sub-dielectric layer is formed, and b2 second sub-dielectric layers constitute the H_{b};
(22) forming the Zₐ along the first direction on the H_{b} formed in step (21) by using a fifth atomic layer deposition process, wherein a process of forming the Zₐ by using the fifth atomic layer deposition process comprises a2 first sub-dielectric layer growth cycles which are cyclically performed; after completing each of the a2 first sub-dielectric layer growth cycles, a first sub-dielectric layer is formed, and a2 first sub-dielectric layers constitute the Zₐ; the H_{b} and the Zₐ, which are formed along the first direction and arranged in a stacked manner, constitute one second unit; and
(23) repeating steps (21) to (22) c2 times to obtain the second stacked layer, wherein a2, b2, and c2 satisfy: 1 ≤ a2/b2 ≤ 20, the c2 represents a number of the second unit in the second stacked layer, the c2 is a positive integer and satisfies 1 ≤ c2 ≤ 50, and 30 ≤ (a2 + b2) * c2 ≤ 60; as well as satisfy: the second stacked layer is represented as (H_{b}Zₐ)_{c2}; in the second stacked layer, c2 second units are stacked along the first direction, a total thickness of the second stacked layer is 2.4 nm to 6 nm, and 1 ≤ a/b ≤ 20; and/or,
forming the third stacked layer comprises:
(31) forming the Zₐ by using a sixth atomic layer deposition process, wherein a process of forming the Zₐ by using the sixth atomic layer deposition process comprises a3 first sub-dielectric layer growth cycles which are cyclically performed; after completing each of the a3 first sub-dielectric layer growth cycles, a first sub-dielectric layer is formed, and a3 first sub-dielectric layers constitute the Zₐ;
(32) forming the H_{b} along the first direction on the Zₐ formed in step (31) by using a seventh atomic layer deposition process, wherein a process of forming the H_{b} by using the seventh atomic layer deposition process comprises b3 second sub-dielectric layer growth cycles which are cyclically performed; after completing each of the b3 second sub-dielectric layer growth cycles, a second sub-dielectric layer is formed, and b3 second sub-dielectric layers constitute the H_{b}; the Zₐ and the H_{b}, which are formed along the first direction and arranged in a stacked manner, constitute one third unit; and
(33) repeating steps (31) to (32) c3 times to obtain the third stacked layer, wherein a3, b3, and c3 satisfy: 1 ≤ a3/b3 ≤ 20, the c3 represents a number of the third unit in the third stacked layer, the c3 is a positive integer and satisfies 1 ≤ c3 ≤ 50, and 30 ≤ (a3 + b3) * c3 ≤ 60; as well as satisfy: the third stacked layer is represented as (ZₐH_{b})_{c3}; in the third stacked layer, c3 third units are stacked along the first direction, a total thickness of the third stacked layer is 2.4 nm to 6 nm, and 1 ≤ a/b ≤ 20.

15. The method according to claim 11, wherein forming the barrier layer comprises: forming the barrier layer by using an eighth atomic layer deposition process, wherein a process of forming the barrier layer by using the eighth atomic layer deposition process comprises d1 sub-barrier layer growth cycles which are cyclically performed; after completing each of the d1 sub-barrier layer growth cycles, a sub-barrier layer is formed, and d1 sub-barrier layers constitute the barrier layer; d1 ranges from 1 to 4, and a thickness satisfying the barrier layer ranges from 0.07 nm to 0.4 nm.
